# FASCICULE DE BREVET EUROPEEN

(11) **EP 2 859 208 B1**
(45) Date de publication et mention de la délivrance du brevet: **27.02.2019**
(21) Numéro de dépôt: 13723850.7
(22) Date de dépôt: 22.04.2013
(51) Int. Cl.: F02C 7/04, F02C 7/14, F02K 3/115, H01L 35/30

(54) **TURBOREACTEUR INCORPORANT DES GENERATEURS THERMOELECTRIQUES**
STRAHLTRIEBWERK MIT THERMOELKTRISCHENGENERATOREN
TURBOJET COMPRISING THERMOELECTRIC GENERATORS

(30) Priorité: 24.04.2012 FR 1253754
(43) Date de publication de la demande: 15.04.2015
(73) Titulaire: Safran Aircraft Engines, 75015 Paris (FR); Safran Electrical & Power, 31702 Blagnac Cedex (FR)
(72) Inventeur: CHARRIER, Jean-Jacques, F-92707 Colombes (FR); BENSAIED, Moëz, F-92707 Colombes (FR); MISSOUT, Marc, F-77550 Moissy-Cramayel cedex (FR); POTTIER, Francis, F-92006 Nanterre (FR); RIBEIRO, Stéphane, F-92006 Nanterre (FR); TABART, Romain, F-92006 Nanterre (FR)
(74) Mandataire: Gevers & Orès
(86) Numéro de dépôt international: PCT/FR2013/050892
(87) Numéro de publication internationale: WO 2013/160602

(56) Documents cités:
- EP-A1- 2 075 194
- EP-A2- 1 746 257
- DE-A1-102007 036 930
- DE-A1-102008 055 946
- US-A1- 2009 159 110

## Description

La présente invention se rapporte aux turbomachines utilisées notamment dans le domaine aéronautique, à la propulsion d'aéronefs. Elle vise en particulier l'application de générateurs thermoélectriques dans celles ci.

### Art antérieur

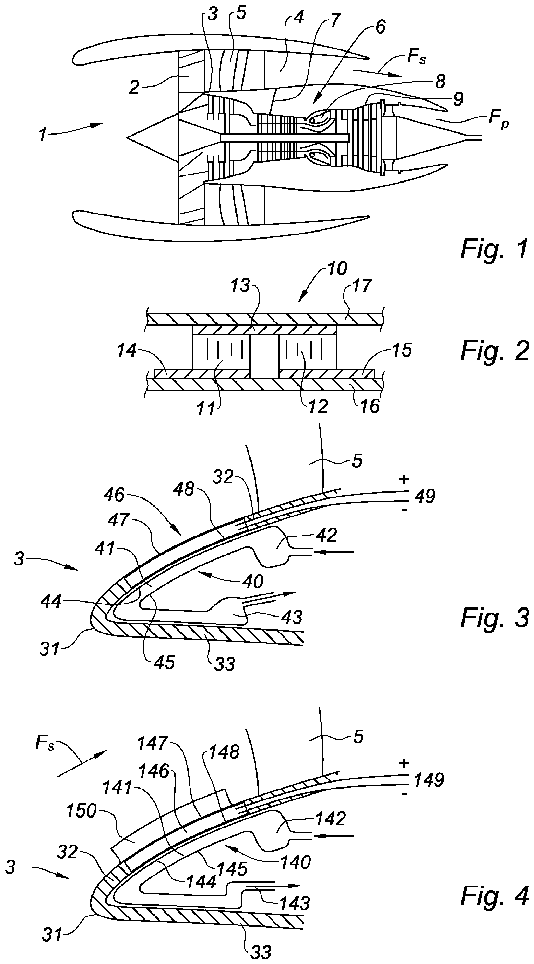

Une turbomachine telle qu'un turboréacteur, pour la propulsion d'aéronefs est généralement multiaxes et à multi-flux. Le turboréacteur représenté sur la figure 1, comprend par exemple pour un moteur à double flux, d'amont en aval une nacelle avec une manche d'entrée d'air guidant l'air aspiré vers un rotor de soufflante 2 en aval duquel et au niveau d'un bec 3 de séparation de flux, le flux d'air comprimé est divisé en deux flux annulaires, concentriques : un flux central primaire Fp et un flux secondaire Fs radialement extérieur au flux primaire. Le flux secondaire est guidé dans un canal de dérivation 4, redressé en 5 dans l'axe XX du moteur, pour être éjecté et produire une part importante de la poussée du moteur sans toutefois avoir été chauffé. Sur l'exemple de la figure 1, les flux primaire et secondaire sont éjectés séparément. Le flux primaire Fp est guidé à travers le corps central 6 qui produit l'énergie nécessaire à l'entraînement du rotor de soufflante 2. Le corps central 6 est une unité à turbine à gaz qui comprend une section de compression 7, à basse et haute pression, alimentant en air comprimé une chambre de combustion 8 où le carburant est injecté et où sont produits les gaz de combustion moteurs dont l'énergie est convertie en partie par la section de turbine 9. Les rotors de turbine sont reliés mécaniquement aux rotors des compresseurs y compris la soufflante et les entraînent en rotation.

Un turboréacteur à soufflante selon le préambule de la revendication 1 est divulgué dans le document EP2075194A1.

Le poids et la consommation de carburant étant deux facteurs pénalisant dans le domaine aéronautique, on cherche en permanence à réduire la masse des composants d'une part et à valoriser l'énergie dissipée non transformée en énergie mécanique d'autre part.

On connaît des cellules thermoélectriques qui en étant disposées entre deux sources de chaleur présentant un gradient de température, l'une chaude, l'autre froide, sont aptes à transformer l'énergie thermique qui les traverse en énergie électrique.

Sur la figure 2, on a représenté un exemple de cellule thermoélectrique 10. Elle comprend deux éléments semi conducteurs 11 et 12, respectivement dopés de type N et de type P. Ces deux éléments sont reliés d'un côté par une connexion électrique 13 et sont terminés chacun de l'autre côté par une autre connexion électrique formant les bornes 14 et 15. La cellule est montée entre deux supports 16 et 17 isolants électriquement mais conducteurs thermiquement. On combine une pluralité de cellules entre les supports 16 et 17 en les connectant électriquement en série par les bornes 14 et 15 ; les cellules sont ainsi disposées en parallèle thermiquement et forment un module générateur thermoélectrique que l'on désigne par la suite GTE.

Un tel module GTE quand il est installé entre deux sources de chaleur, l'une chaude à température élevée en contact thermique avec le support 16, l'autre froide à température inférieure en contact avec l'autre support 17 est susceptible de produire un courant électrique entre les bornes 14 et 15 où les bornes mises en série. L'efficacité du module GTE dépend de plusieurs facteurs dont la nature des matériaux constituant les semi conducteurs, le nombre de jonctions PN, leur section, leur géométrie, leur épaisseur et, pour un module donné, la différence de température entre la source chaude et la source froide.

Il a déjà été proposé de valoriser l'énergie dissipée dans un moteur à turbine à gaz et plus particulièrement dans un turboréacteur.

Ainsi la société Turboméca a développé un agencement de générateurs thermoélectriques dans un moteur à turbine à gaz propulsant un aéronef, décrit dans la demande de brevet WO 2010/089505. Il est formé d'éléments annulaires concentriques comportant chacun une pluralité de cellules thermoélectriques. Les éléments annulaires ménagent entre eux des canaux de circulation de gaz froid et des canaux de circulation de gaz chauds. Les canaux sont aussi concentriques et communicants. Un fluide froid balaye une face de chacun des éléments et un fluide chaud balaye la face opposée de ces éléments. Les fluides susceptibles d'être utilisés respectivement comme source froide ou chaude peuvent être le carburant du moteur, son huile de refroidissement ou de lubrification, l'air extérieur, l'air prélevé au compresseur ou des gaz prélevés au flux de gaz éjecté en aval de la turbine.

L'énergie électrique produite par ce dispositif est utilisée pour alimenter les accessoires du moteur comme par exemple le Fadec ou bien des pompes entraînées par des moteurs électriques.

### Présentation de l'invention

La présente invention vise une autre application des GTE dans les moteurs d'aéronef.

C'est ainsi que l'invention a pour objet un turboréacteur à soufflante avant selon la revendication 1.

Le fluide à refroidir, huile principalement, provient des organes et des équipements du moteur qui dissipent de la chaleur résultant des frottements internes et qui ont un besoin en lubrification et en refroidissement. Il s'agit par exemple des enceintes de roulements des différents arbres rotatifs et des engrenages d'entraînement des auxiliaires.

L'important gradient de température entre les fluides ainsi à refroidir et l'air circulant dans la veine en aval de la soufflante contribue, toutes choses étant égales par ailleurs à assurer une efficacité optimale des générateurs thermoélectriques.

La solution de l'invention permet donc de contribuer au refroidissement de ces fluides tout en récupérant une partie de l'énergie thermique qui aurait été autrement perdue. L'énergie électrique produite est fonction de l'étendue de la surface de la source froide et est avantageusement utilisée pour alimenter des organes tels que les actionneurs des aubes statoriques de redresseurs à géométrie variable ménagés entre les étages de compresseur, désignées VSV dans le domaine et les vannes de décharge des compresseurs, désignées VBV.

Selon l'invention, la première surface du générateur thermoélectrique est intégrée à un élément de paroi du bec de séparation, situé en aval du bord d'attaque de celui-ci, du côté de la veine de flux secondaire. Eventuellement la première surface du GTE peut être intégrée à la structure de la paroi de la nacelle, celle-ci étant conductrice thermiquement.

Par cette caractéristique, l'agencement de l'invention permet de réduire les pertes de charge aérodynamiques susceptibles d'être engendrées par les éléments de l'échangeur en contact avec le flux d'air.

Plus particulièrement, il est avantageux d'installer la première surface en amont des ailettes fixes de guidage agencée pour redresser le flux d'air secondaire. En effet, on dispose d'un espace suffisant dans cette zone définie entre le bord d'attaque du bec de séparation et les ailettes de guidage, désignée OGV pour « outlet guide vanes ».

Conformément à un autre mode de réalisation, ledit élément de paroi du bec de séparation disposé en aval de l'arête de séparation des flux d'air comprend des ailettes radiales en échange thermique avec le flux d'air secondaire. Cette solution bien que moins performante aérodynamiquement permet d'accroître les échanges thermiques entre les générateurs thermodynamiques et le flux d'air secondaire lorsque cela se révèle être nécessaire.

### Brève description des figures

L'invention sera mieux comprise, et d'autres buts, détails, caractéristiques et avantages de celle-ci apparaîtront plus clairement au cours de la description explicative détaillée qui va suivre, d'un mode de réalisation de l'invention donné à titre d'exemple purement illustratif et non limitatif, en référence aux dessins schématiques annexés.

Sur ces dessins :
La figure 1 montre en coupe dans un plan passant par l'axe de la machine, un turboréacteur à double flux sur lequel l'invention peut être mise en oeuvre ;
La figure 2 représente de façon schématique un exemple de cellule thermoélectrique pouvant être utilisée dans l'invention ;
La figure 3 montre en coupe une vue partielle du bec de séparation du turboréacteur de la figure 1 auquel selon l'invention un dispositif thermoélectrique est appliqué ;
La figure 4 est une variante d'installation par rapport à celle de la figure 3.

### Description détaillée de l'invention

En se reportant à la figure 1, le flux d'air comprimé par la soufflante 2 est divisé en deux flux concentriques annulaires, primaire et secondaire, en passant par le bec 3 de séparation de flux. Le flux d'air primaire est ainsi guidé par des ailettes de guidage, désignées IGV et non représentées, dans le corps central et le flux secondaire est guidé dans le canal de flux froid délimité entre, intérieurement, l'enveloppe du corps central et extérieurement la nacelle de soufflante.

Le flux d'air annulaire issu de la soufflante est divisé en les deux flux concentriques par le bord amont annulaire de la nacelle du corps central 6 et formant le bec 3 de séparation de flux, représenté à plus grande échelle sur la figure 3.

Le bec de séparation est à section, dans un plan radial contenant l'axe XX du moteur, sensiblement triangulaire ; il comprend une portion de paroi 32 s'étendant vers l'aval, depuis la ligne d'arête annulaire amont formant le bord d'attaque 31. Cette portion de paroi délimite, radialement intérieurement, la partie amont de la veine de flux secondaire. Elle se prolonge le long de la veine secondaire après les ailettes 5 de guidage, OGV, agencées pour redresser dans l'axe XX le flux secondaire.

Le bec de séparation de flux comprend depuis le bord d'attaque 31 une portion de paroi 33 qui délimite radialement extérieurement une partie amont de la veine de flux primaire.

Ce bec de séparation ménage ainsi un espace, entre les deux éléments de parois 32 et 33, dont le volume est suffisant pour loger un échangeur de chaleur air/huile.

On a représenté sur la figure 3 un exemple d'agencement d'échangeur incorporant un générateur thermoélectrique.

L'échangeur 40 comprend une enceinte 41 parcourue par le fluide à refroidir et ménagée entre deux parois 44 et 45 parallèles entre elles le long de la face interne de l'élément de paroi 32 de la veine secondaire. Le fluide pénètre dans cette enceinte par une entrée 42 communiquant avec le circuit par un conduit tubulaire. A l'intérieur de l'enceinte 41 est ménagé un circuit assurant un échange thermique optimal avec la paroi radialement extérieure 44. L'enceinte comprend une sortie de fluide 43 communiquant par un conduit tubulaire avec le circuit de fluide. Les canaux intérieurs de l'enceinte forment par exemple un serpentin à direction principale axiale ou périphérique.

La paroi radialement extérieure 44 est en contact thermique avec un module générateur thermoélectrique 46 et forme la source chaude de celui-ci. Le module générateur thermoélectrique comprend une pluralité de cellules thermoélectriques telles que décrites avec la figure 2, celles-ci étant montées entre deux parois thermiquement conductrices 47 et 48. La paroi 48 est en contact thermique avec la paroi radialement extérieure 44 de l'enceinte 40 parcourue par le fluide à refroidir.

La paroi opposée 47 du module GTE est intégrée à la paroi 32 interne de la veine de flux secondaire ou est en contact thermique avec un élément de paroi constituant la nacelle du corps central 6. Ladite paroi est donc à la température de l'air du flux secondaire Fs.

Le module choisi dépend de la surface disponible pour l'implantation des GTE. Les paramètres à prendre en considération sont les matériaux qui les composent, le nombre de jonction PN, leur section, leur géométrie, leur épaisseur. On vise de préférence un module dont la résistance thermique est aussi basse que possible pour ne pas diminuer le rendement de l'échangeur de chaleur.

En fonctionnement du moteur lorsque l'aéronef est en vol, l'écart de température entre les deux parois 47 et 48 crée une différence de potentiel entre les bornes des éléments semi conducteurs, fournissant un courant électrique. Le courant électrique en 49 peut être distribué aux organes du turboréacteur à alimentation électrique.

Sur la figure 4 on a représenté une variante de réalisation. Les mêmes éléments que ceux de la figure 3 portent la même référence plus 100.

L'échangeur de chaleur 140 comprend une entrée de fluide 142 et une sortie de fluide 143 entre les parois 144 et 145 de l'enceinte 141 qui est disposée en contact thermique avec le générateur thermoélectrique 146. La paroi chaude 148 du GTE 146 est en contact thermique avec la paroi 144 de l'échangeur. La paroi froide 147 du GTE est en contact thermique avec des ailettes 150 qui s'étendent radialement depuis la paroi 32 du bec de séparation 3.

Comme précédemment le courant électrique produit par le GTE est recueilli aux bornes de fils conducteurs 149 pour être distribué aux organes appropriés.

## Revendications

1. Turboréacteur à soufflante avant comportant au moins un circuit de fluide et un échangeur air/fluide (40, 140) par lequel ledit fluide est refroidi par de l'air extérieur au turboréacteur et un bec (3) de séparation du flux en aval de la soufflante entre un flux primaire et un flux secondaire, **caractérisé par le fait que** l'échangeur de chaleur (40, 140) est associé à un générateur thermoélectrique (46, 146) comportant une première (47, 147) et une seconde (48, 148) surfaces d'échange thermique dont la première surface est en contact thermique avec ledit flux d'air et la seconde surface est en contact thermique avec le fluide à refroidir dans l'échangeur (40, 140), ladite première surface (47, 147) étant intégrée à un élément de paroi (32) du bec de séparation situé en aval du bord d'attaque (31) du bec de séparation des flux d'air, du côté de la veine de flux secondaire (Fs) .

2. Turboréacteur selon la revendication 1 dont ladite première surface (47, 147) est en amont des ailettes (5) fixes de guidage de redressement de flux secondaire (Fs).

3. Turboréacteur selon l'une des revendications 1 et 2 dont ledit élément (32) de paroi du bec de séparation en aval du bord d'attaque (31) comprend des ailettes (150) radiales en échange thermique avec le flux d'air.

## Patentansprüche

1. Turbostrahltriebwerk mit Frontgebläse, das zumindest einen Fluidkreislauf und einen Luft-/Fluidtauscher (40, 140), durch den das Fluid durch Außenluft am Turbostrahltriebwerk gekühlt wird, und eine Nase (3) zum Trennen des Stroms stromabwärts des Gebläses zwischen einem Primärstrom und einem Sekundärstrom aufweist, **dadurch gekennzeichnet, dass** der Wärmetauscher (40, 140) mit einem thermoelektrischen Generator (46, 146) verbunden ist, der eine erste (47, 147) und eine zweite (48, 148) thermische Austauschfläche aufweist, dessen erste Fläche in thermischem Kontakt mit dem Luftstrom steht und dessen zweite Fläche in thermischem Kontakt mit dem zu kühlenden Fluid im Tauscher (40, 140) steht, wobei die erste Fläche (47, 147) in ein Wandelement (32) der Nase zum Trennen integriert ist, das sich stromabwärts der Angriffskante (31) der Nase zum Trennen der Luftströme, auf der Seite des Stroms des Sekundärstroms (Fs) befindet.

2. Turbostrahltriebwerk nach Anspruch 1, dessen erste Fläche (47, 147) stromaufwärts der festen Führungsrippen (5) zum Gleichrichten des Sekundärstroms (Fs) liegt.

3. Turbostrahltriebwerk nach einem der Ansprüche 1 und 2, dessen Wandelement (32) der Nase zum Trennen stromabwärts der Angriffskante (31) radiale Rippen (150) umfasst, die in thermischem Austausch mit dem Luftstrom stehen.

## Claims

1. Front-fan turbojet engine comprising at least one fluid circuit and an air/fluid exchanger (40, 140) by means of which said fluid is cooled by air external to the turbojet engine and a splitter (3) for splitting the flow downstream of the fan between a primary flow and a secondary flow, **characterised in that** the heat exchanger (40, 140) is associated with a thermoelectric generator (46, 146) comprising a first (47, 147) and a second (48, 148) thermal exchange surface, of which the first surface is in thermal contact with said airflow and the second surface is in thermal contact with the fluid to be cooled in the exchanger (40, 140), said first surface (47, 147) being integrated to a wall element (32) of the splitter, which element is located downstream of the leading edge (31) of the splitter of the airflows, on the side of the secondary flow path (Fs).

2. Turbojet engine according to claim 1, wherein said first surface (47, 147) is upstream of the fixed guiding fins (5) for straightening the secondary flow (Fs).

3. Turbojet engine according to either claim 1 or claim 2, wherein said wall element (32) of the splitter, which element is downstream of the leading edge (31), comprises radial fins (150) exchanging heat with the airflow.
